## Europäisches Patentamt

## European Patent Office

## Office européen des brevets

(11) Publication number: **0 041 844**
**B1**

## EUROPEAN PATENT SPECIFICATION

(45) Date of publication of patent specification: **30.12.86**

(51) Int. Cl.⁴: **H 01 L 27/02, G 11 C 5/00**

(21) Application number: **81302502.0**

(22) Date of filing: **05.06.81**

(54) Semiconductor integrated circuit devices.

(30) Priority: **10.06.80 JP 78188/80**

(43) Date of publication of application:
**16.12.81 Bulletin 81/50**

(45) Publication of the grant of the patent:
**30.12.86 Bulletin 86/52**

(84) Designated Contracting States:
**DE FR GB NL**

(56) References cited:
**US-A-3 760 384**

**ELECTRONICS, vol. 51, no. 21, 12th October 1978, pages 67-68; "LSI chip provides 600-gate array in semi-custom setup"**

**IEEE TRANSACTIONS ON ELECTRON DEVICES, vol. ED-26, no. 4, April 1979, pages 333-334; P.W. COOK et al.: "1 mum MOSFET VLSI technology: Part III - Logic circuit design methodlogy and applications"**

(73) Proprietor: **FUJITSU LIMITED**
**1015, Kamikodanaka Nakahara-ku**
**Kawasaki-shi Kanagawa 211 (JP)**

(72) Inventor: **Itoh, Hideo**
**1726, Kamikodanaka Nakahara-ku**
**Kawasaki-shi Kanagawa, 211 (JP)**
Inventor: **Yamauchi, Takahiko**
**Room 2F-1 Iseyaso 49, Kitaya-cho, Nakahara-ku**
**Kawasaki-shi Kanagawa, 211 (JP)**

(74) Representative: **Sunderland, James Harry et al**
**HASELTINE LAKE & CO Hazlitt House**
**28 Southampton Buildings Chancery Lane**
**London WC2A 1AT (GB)**

Courier Press, Leamington Spa, England.

## Description

This invention relates to semiconductor integrated circuit devices, for example semiconductor memory devices.

A semiconductor memory device includes bonding pads which receive input signals, various kinds of buffer circuits such as an address buffer circuit, a write-in buffer circuit, a read-out buffer circuit, the major function of which buffer circuits is to amplify signals received by or generated in the semiconductor memory device, perhaps some logic circuits for miscellaneous purposes, a decoder circuit which, of course, decodes signals or transforms the format of signals, and memory cells.

One of the essential requirements which a memory device must satisfy relates to the transmission speed of signals in the memory device — this speed should be as high as possible. This speed is primarily determined by a time constant, or a resistance/capacitance product. Therefore, the provision of reduced resistance in a semiconductor memory device is important.

On the other hand, another of the important requirements which a semiconductor memory device must satisfy relates to the degree of integration, which should be as high as possible.

For these reasons, the layout of each component or ingredient constituting a semiconductor memory device is one of the important parameters involved in design of a semiconductor memory device.

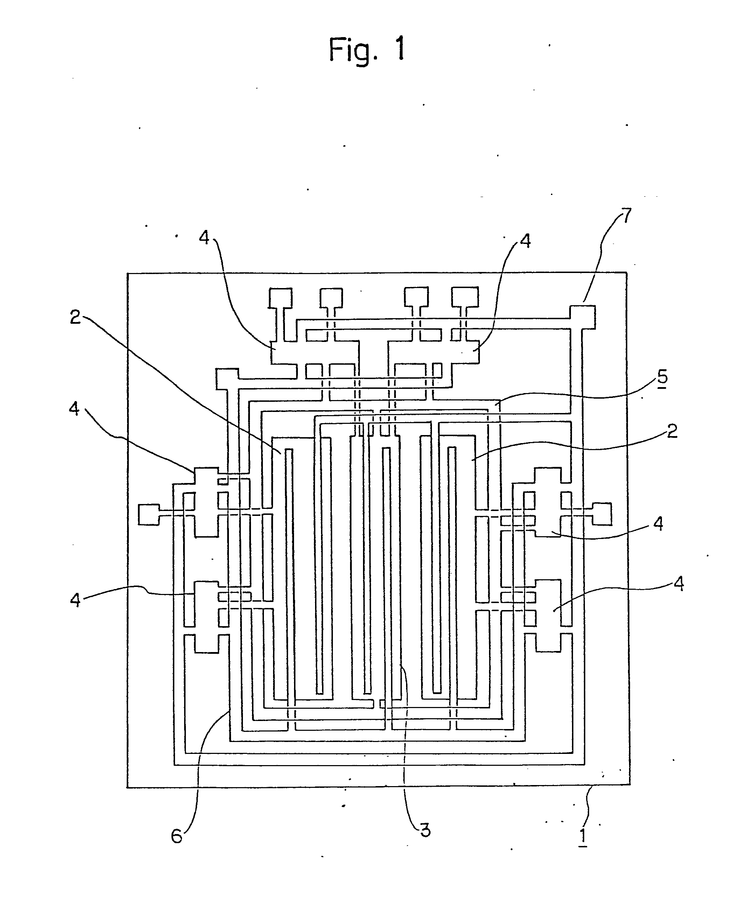

Figure 1 of the accompanying drawings is a schematic illustration of one example of a layout of component elements or ingredients constituting a previously proposed semiconductor memory device. It will be seen by reference to Figure 1, that a feature of the illustrated layout is that a ground line (GND) 7 placed around the external edges of the semiconductor memory device 1 surrounds various control circuits 4 such as an address buffer circuit, a write-in buffer circuit, and a read-out buffer circuit and logic circuits, and that these control circuits further surround an electric power supply line (Vcc) 6, which in turn surrounds a group of signal lines 5 each of which connects the various control circuits 4 with one another, and that finally the signal lines surround memory cell areas 2 and a decoder circuit 3 at the centre of the semiconductor memory device 1.

A major advantage of this conventional layout as illustrated in Figure 1 is that the electric power supply line (Vcc) 6 is not required to cross the ground (GND) line 7, both of which lines have a relatively large current capacity, so that there is no requirement for a so-called bridge between these lines. A "bridge" is a structure in which one line crosses under the other line via a diffusion layer formed in the substrate, or a structure in which one line crosses over the other line with an insulator layer therebetween. This absence of a requirement for a bridge between these two lines effectively avoids voltage drop inevitable at a bridge, and as a further result excludes the possibility of malfunction caused by such a voltage drop. However, the conventional layout illustrated in Figure 1 inevitably includes a considerable number of so-called bridges between the memory cell areas 2 and the decoder circuit 3, both of which are placed at the centre of the memory device 1, and the control circuits 4, such as buffer circuits and logic circuits, which are disposed around areas 2 and circuit 3, and between control circuits 4 and bonding pads which are placed around the edges of the semiconductor memory device 1.

The so-called bridges mentioned above are a type of multi-layered connection. Therefore, bridges usually cause a considerable increase in magnitude of resistance of a line involved. This increase in resistance, in combination with capacitances, which inevitably arise in a semiconductor memory device, can cause a considerable increase in magnitude of a time constant, resulting in a considerable increase in magnitude of a single transmission delay. Due to the nature of the memory device, a slow signal transmission speed is an unacceptable drawback for lines connecting control circuits, particularly buffer circuits, and the decoder circuit, and for output signal lines connecting the memory cells and the output bonding pads.

Attention is directed to US—A—3 760 384. In the FET memory array chip illustrated in Figure 1 of the cited document, power supply lines are placed between the control circuits and the internal circuits. For example, ground voltage line 114A lies between the word decoder 128 and FET devices 162 of the internal circuit 106, and wiring lines which connect the word decode 128 and FET devices 162 cross the ground voltage line 114A. Wiring lines which connect the control circuits (126, 128, 130) and the internal circuits (102, 104, 106, 108, 132) cross the ground voltage line.

An embodiment of this invention can provide a semiconductor memory device in which signal transmission speed is improved for lines connecting control circuits, particularly buffer circuits, and a decoder circuit.

A semiconductor memory device embodying the present invention is provided with (1) a plurality of memory cells and a decoder circuit arranged centrally of the device, (2) at least one ground line arranged so as to surround (extend around or outside of) the plurality of memory cells and the decoder circuit, (3) at least one control circuit, such as a buffer circuit and/or, perhaps, a logic circuit, which is arranged beneath or in an area outside of the loop followed by the ground line and of which the terminals connected to the memory cells and/or the decoder circuit are arranged inwardly (e.g. of the control circuit concerned) or inside the loop of the ground line and of which the terminals connected to another control circuit or other control circuits, such as buffer circuits and/or logic circuits, if any, are arranged outwardly (e.g. of the control circuit to which the terminal belongs) or outside the loop of the ground line, (4) a plurality of signal lines connecting the control circuits with each other specifically connecting the buffer circuits with each other, connecting the buffer circuits and logic circuits, if any, or connecting logic circuits with each other, if any, arranged in an area surrounding or outside the ground line and the control circuits, (5) at least one electric power supply line arranged surrounding the signal lines or outside the loop followed by the signal lines, and (6) a plurality of bonding pads arranged outside the loop followed by the electric power supply line.

When a control circuit is arranged beneath the ground line, these two component elements can be connected through vertical lines, of course, excluding bridges. Such vertical lines, for example, may be connection lines extending perpendicularly to the surface of a substrate of the semiconductor device. The terminal arrangement described at (3) above can be made possible by arranging the ground line on top of active elements such as transistors or diodes constituting each of the control circuits such as buffer circuits and, perhaps, logic circuits.

This layout of the components constituting a semiconductor memory device is effective (1) to exclude bridges from the lines connecting the control circuits, such as buffer circuits and logic circuits, if any, and the decoder circuit or memory cells and (2) to exclude bridges from the lines connecting the control circuits, such as buffer circuits and logic circuits, if any, with each other. Thereby the transmission speed of signals can be considerably improved between each of the control circuits, such as buffer circuits and logic circuits, and the or each decoder circuit and memory cells, and between one control circuit and another.

Another embodiment of the present invention is provided in which (1) the ground line and some or all of the signal lines are partly or entirely arranged on top of some or all of the control circuits such as buffer circuits and logic circuits, if any, and (2) the terminals of the control circuits connected with the memory cells or the decoder circuits are arranged inwardly (e.g. of the control circuits) and the terminals of the control circuits connected to the electric power supply line or to the bonding pads are arranged outwardly (e.g. of the control circuits). The latter terminal arrangement is made possible by arranging lines on top of active elements such as transistors or diodes. This layout is effective to exclude bridges crossing the signal lines. Needless to emphasise, vertical lines are employed for connection of the control circuits arranged beneath the ground line, and the signal lines and these lines.

A further embodiment of the present invention is provided in which a portion of the ground line is discontinued (e.g. the ground line does not extend around a complete loop — the ground line is omitted from a part of the loop to provide a gap or discontinued area) to allow the electric power supply line and some of the signal lines to pass through this discontinued area to reach for example the decoder circuits. This layout is effective to exclude more bridges.

Another embodiment of the present invention is provided in which (1) the ground line is shortened to allow the electric power supply line to pass through an area from which the electric power supply line is partly removed, to reach the memory cells and decoder circuit, and (2) some of the control circuits, particularly the address buffer circuit and the write-in buffer circuit, are grounded through a branch of the ground line arranged on top of the decoder circuit. This layout is effective to entirely exclude bridges between the electric power supply line and the ground line.

All of the above mentioned embodiments of the present invention can be modified by exchanging the ground line and the electric power supply line.

A semiconductor memory device embodying the present invention can provide for improved transmission speed for signals which are transmitted between memory cells and/or a decoder circuit and control circuits such as buffer circuits and logic circuits.

Reference is made, by way of example, to the accompanying drawings, in which:—

Figure 1 is a schematic diagram illustrating one example of the layout of a previously proposed semiconductor memory device,

Figure 2 is a schematic diagram illustrating the layout of a semiconductor memory device embodying this invention,

Figure 3 is a schematic diagram, similar to Figure 2, illustrating another semiconductor memory device embodying this invention, and

Figure 4 is a schematic diagram, similar to Figure 2, illustrating a further semiconductor memory device embodying this invention.

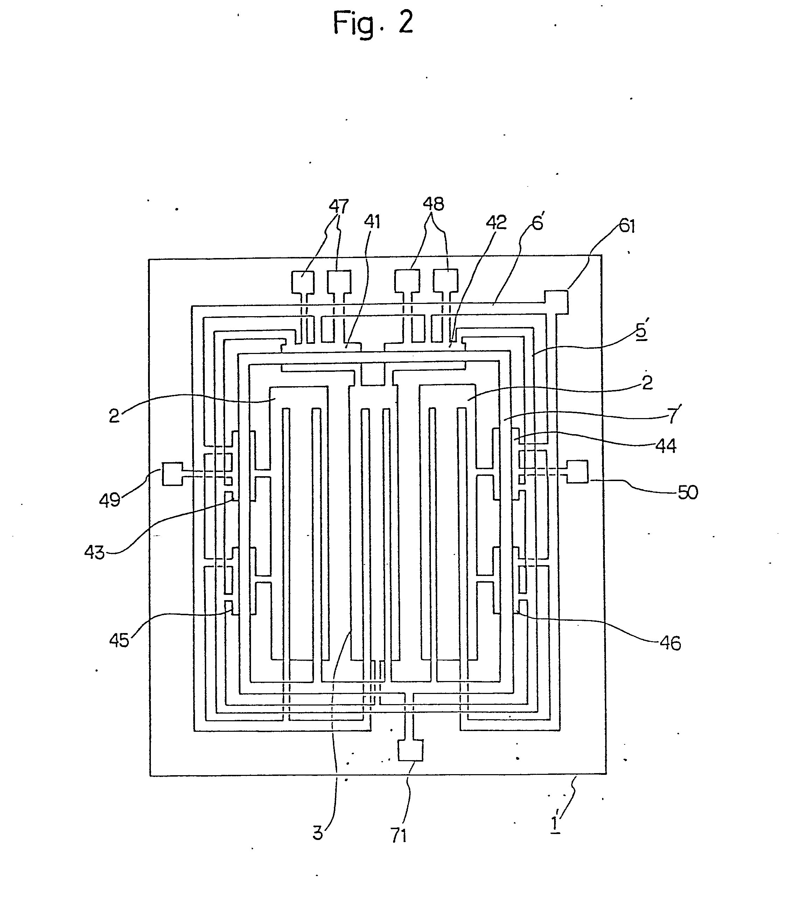

Referring to Figure 2, 1' is a semiconductor memory device. Memory cells 2 and a decoder circuit or decoder circuits 3 are arranged centrally of the semiconductor memory device 1'. A ground line (GND) 7' (a first electric power supply line) is arranged to surround (extend around or outside) the above mentioned components 2 and 3. A bonding pad 71 is employed for grounding the ground line (GND) 7'. Buffer circuits and logic circuits, such as an address buffer circuit 41, a write-in buffer circuit 42, read-out buffer circuits 43 and 44, and logic circuits 45 and 46 are arranged beneath the ground line (GND) 7'. The ground line 7' and each of the buffer circuits 41 to 44 and the logic circuits 45 and 46 are connected through vertical lines, thereby avoiding the need for bridges for connection of these components. The terminals for connection of the buffer circuits 41 to 44, or the logic circuits 45 and 46, to the decoder circuit 3 or the memory cell areas 2, are arranged inwardly or towards the area surrounded by the loop of the ground line 7', resultantly excluding the need for bridges for connection of these components. On the other hand, the terminals for connection of the buffer circuits 41 to 44, or the logic circuits 45 and 46, with each other, are arranged outwardly or towards an area surrounded by a loop followed by signal lines 5', resultantly excluding the need for bridges for connection of these components due to the arrangement of signal lines 5' connecting the buffer circuits 41 to 44 or logic circuits 45 and 46 with each other in the area surrounding these components. These signal lines 5' respectively transmit control signals for the buffer circuits. The aforementioned terminal arrangement is readily possible by arranging the ground line 7' on top of active devices, such as transistors or diodes, which constitute the buffer circuits 41 to 44, or logic circuits 45 and 46. An electric power supply line (Vcc) 6' (a second electric power supply line) is arranged to further surround (extend around) the signal lines 5', or in the outermost area of the semiconductor memory device 1'. A bonding pad 61 is also arranged in this area to supply electric power to the electric power supply line 6'. Other bonding pads 47 to 50 are arranged along the edges of the semiconductor memory device 1'.

In this embodiment of the present invention, bridges still remain (1) for connection of the electric power supply line 6' and some of the buffer circuits, specifically read-out buffers 43 and 44 or logic circuits 45 and 46, (2) for connection of the electric power supply line 6' and the memory cell areas 2 and the decoder circuit 3, (3) for connection of the address buffer 41 and its bonding pad 47, (4) for connection of the write-in buffer 42 and its bonding pad 48, and (5) for connection of each of the read-out buffer circuits 43 and 44 and each of their bonding pads 49 and 50. These connection lines having bridges inevitably suffer from somewhat larger amounts of resistance and capacitance than lines without bridges, resulting in a somewhat reduced signal transmission speed or in more delay in signal transmission. It is noted in this embodiment of the present invention, however, that bridges are entirely excluded from all of the lines for which a high signal transmission speed is required. Specifically, it is a significant advantage that all the lines connected to the terminals of the buffer circuits 41 to 44 and of the logic circuits 45 and 46 which are arranged inwardly or inside the ground lines 7' and all the signal lines 5' are entirely free from bridges. One of the factors determining the access time to a memory cell in the memory cell areas 2 is the signal transmission speed through the lines connecting the buffer circuits, and the decoder circuit and the memory cell.

Accordingly, this embodiment of the present invention provides a semiconductor memory device in which signal transmission speed is improved for lines connecting buffer circuits and a decoder circuit.

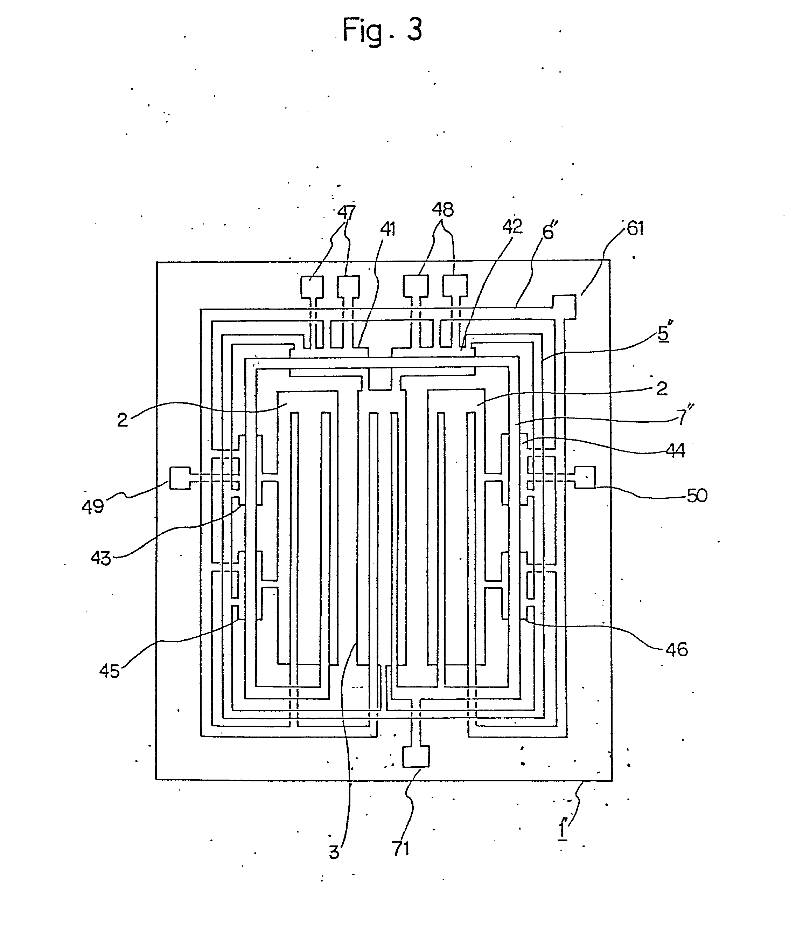

Referring to Figure 3, illustrating the layout of a semiconductor memory device 1'' in accordance with another embodiment of this invention, it will be noted that the layout of this embodiment is similar to that of the embodiment the layout of which is illustrated in Figure 2, except that a portion of the ground line (GND) 7'' is discontinued or omitted, as compared with the complete line loop provided in Figure 2, to allow electric power supply line (Vcc) 6'' and some or a portion of the signal line 5'' to pass through the area in which the line 7'' is discontinued or omitted without employing bridges. This means that two bridges present in the embodiment of Figure 2 are not present in the embodiment of Figure 3.

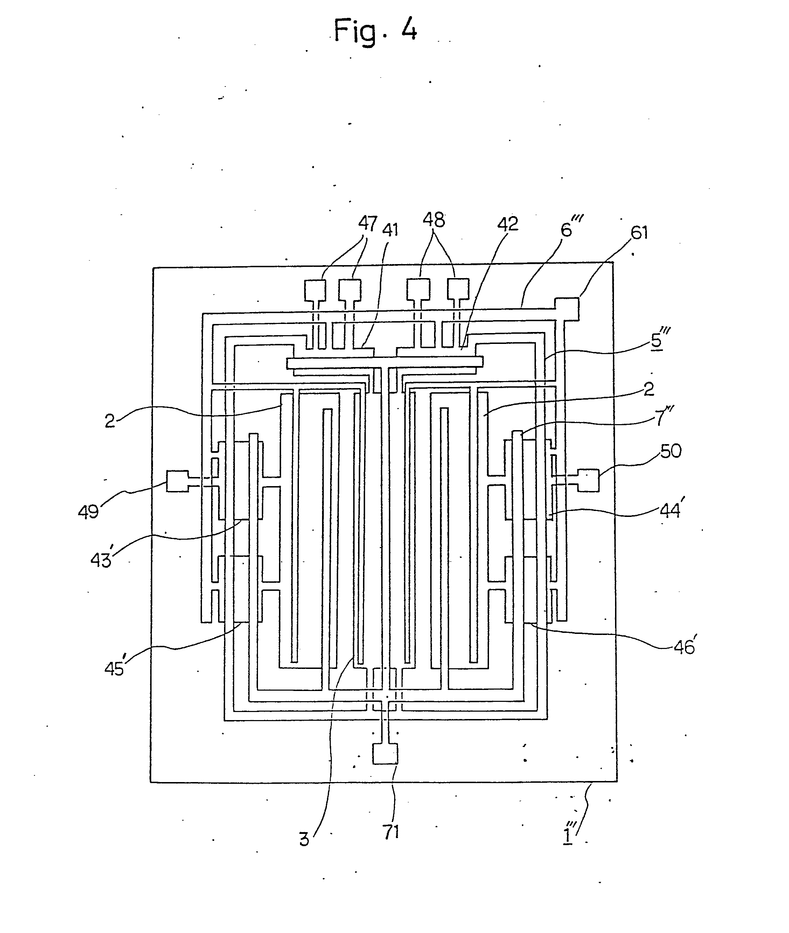

Referring to Figure 4, which illustrates the layout of a semiconductor memory device 1''' in accordance with a further embodiment of this invention, it will be noted that a ground line (GND) 7''' is shortened (as compared with the line 7'' in Figure 3 or line 7' in Figure 2) to allow an electric power supply line (Vcc) 6''' to pass through an area from which a portion of the ground line 7''' is removed or omitted, to reach the memory cell areas 2 and the decoder circuit 3, and some of the buffer circuits, specifically the address buffer 41 and the write-in buffer 42, are grounded through a branch of the ground line 7''' arranged on top of the decoder circuit 3 and generally T-shaped with the top of the "T" over the buffers 41 and 42. Incidentally, electric power supply line 6''' is also shortened. As a result, the ground line 7''' and the electric power supply line 6''' reach each buffer circuit and each logic circuit without the need for bridges, causing a lesser magnitude of voltage drop for these lines. It is additionally noted in this embodiment that not only the ground line 7''' but some of signal lines 5''' are arranged on top of some of buffer circuits 43' and 44' and/or logic circuits 45' and 46', effectively excluding bridges between the buffer circuits 43' and 44', as well as logic circuits 45' and 46', and the electric power supply line 6''', and between the outgoing bonding pads 49 and 50 and the signal line 5''', in addition to the exclusion of bridges due to the use of vertical connections. This exclusion of bridges is realised with a terminal arrangement similar to that described in connection with the embodiment of Figure 2. Such a terminal arrangement is made possible by arranging the ground line 7''' and the signal lines 5''' on top of active elements, such as transistors or diodes, which constitute buffer circuits 43' and 44', or logic circuits 45' and 46'.

It is not necessary to emphasise that the embodiment of Figure 4 maintains the advantages inherent in the present invention. More specifically, all lines connected to terminals of buffer circuits 41, 42, 43' and 44' and of the logic circuits 45' and 46' which are arranged inwardly or inside the ground line 7''', and most of the signal lines 5''' are free from bridges. No significant improvements are applied to bonding pads 47 to 50 and 61' and 71.

This embodiment of the present invention can offer a memory cell access time improved by a few nanoseconds.

Accordingly, various types of memory devices embodying this invention offer improved signal transmission speed for lines connecting buffer circuits and a decoder circuit.

It will be appreciated that functions similar to those of the described embodiments can be realised by exchanging the locations of a ground line and an electric power supply line.

In a semiconductor memory device embodying this invention the layout of each component is such as to exclude unnecessary crossings of specific lines connecting the components, thereby reducing the resistances of lines connecting specific components, resultingly increasing signal transmission speed in the specific lines. In a semiconductor memory device embodying this invention signal transmission speed can be improved for lines connecting control circuits, particularly buffer circuits and a decoder circuit, by excluding crossings from the lines involved.

It will be understood that embodiments of the present invention can be comprised in semiconductor integrated circuit devices other than memory devices, for reducing signal transmission delay.

## Claims

1. A semiconductor integrated circuit device, comprising a plurality of internal circuits disposed centrally thereof, a plurality of control circuits disposed in an area outwards of the internal circuits, a plurality of wiring lines connecting the control circuits and the internal circuits, a plurality of signal lines connecting the control circuits with one another and a first power supply line (which may be a ground line) for supplying the internal circuits and the control circuits, wherein the signal lines and the first power supply line are disposed outwardly of an area in which the plurality of wiring lines connecting the control circuits and the internal circuits are disposed.

2. A device as claimed in claim 1, wherein the first power supply line is disposed inwardly of an area in which the signal lines are disposed and inwardly of an area in which the control circuits are disposed, or over the control circuits.

3. A device, as claimed in claim 1 or 2, being a memory device, comprising a plurality of memory cells and decoder circuitry as the said plurality of internal circuits, wherein a second power supply line (which may be a ground line) is disposed in an area outside the area in which the signal lines are disposed.

4. A device as claimed in claim 3, wherein the or each control circuit is disposed in an area outwards of the area in which the first supply line is disposed.

5. A device as claimed in claim 3, wherein the or each control circuit is disposed beneath the first supply line.

6. A device as claimed in claim 3, 4 or 5, wherein the first supply line is a ground line, and the second supply line is a power line.

7. A device as claimed in claim 3, 4 or 5, wherein the first supply line is a power line, and the second supply line is a ground line.

8. A device as claimed in any one of claims 3 to 7, wherein the first supply line forms a complete loop around the memory cells and decoder circuitry.

9. A device as claimed in any one of claims 3 to 7, wherein the first supply line forms a discontinuous loop, around the memory cells and decoder circuitry, affording a gap therein through which connections are made from the second power supply line and from a signal line or signal lines to the decoder circuitry.

10. A device as claimed in any one of claims 3 to 7, wherein the first supply line has free ends between which a gap is afforded through which connection is made from the second power supply line to the memory cells and decoder circuitry, and wherein the first supply line is provided with a branch extending over the decoder circuitry for connection to a control circuit or control circuits.

11. A device as claimed in any one of claims 3 to 10, wherein the or each signal line forms a complete loop.

## Patentansprüche

1. Integrierte Halbleiterschaltungsvorrichtung, mit einer Vielzahl von internen Schaltungen, die in ihrer Mitte angeordnet sind, einer Vielzahl von Steuerschaltungen, die in einem Bereich außerhalb der internen Schaltungen angeordnet sind, einer Vielzahl von Verdrahtungsleitungen, die die Steuerschaltungen und die internen Schaltungen verbinden, einer Vielzahl von Signalleitungen, die die Steuerschaltungen miteinander verbinden, und einer ersten Energieversorgungsleitung (die eine Erdleitung sein kann), um die internen Schaltungen und die Steuerschaltungen zu versorgen, wobei die Signalleitungen und die erste Energieversorgungsleitung außerhalb eines Bereichs, in dem die Vielzahl von Verdrahtungsleitungen die Steuerschaltungen und die internen Schaltungen verbinden, angeordnet sind.

2. Vorrichtung nach Anspruch 1, bei der die erste Energieversorgungsleitung innerhalb eines Bereichs, in dem die Signalleitungen angeordnet sind, und innerhalb eines Bereichs, in dem die Steuerleitungen angeordnet sind, oder über den Steuerschaltungen angeordnet ist.

3. Vorrichtung nach Anspruch 1 oder 2, die eine Speichervorrichtung ist, mit einer Vielzahl von Speicherzellen und Dekodierschaltungen als die genannte Vielzahl von internen Schaltungen, bei der eine zweite Energieversorgungsleitung (die eine Erdleitung sein kann), in einem Bereich außerhalb des Bereich angeordnet ist, in dem die Signalleitungen angeordnet sind.

4. Vorrichtung nach Anspruch 3, bei der die oder jede Steuerschaltung in einem Bereich außerhalb des Bereichs angeordnet ist, in dem die erste Versorgungsleitung angeordnet ist.

5. Vorrichtung nach Anspruch 3, bei der die oder jede Steuerschaltung unterhalb der ersten Versorgungsleitung angeordnet ist.

6. Vorrichtung nach Anspruch 3, 4 oder 5, bei der die erste Versorgungsleitung eine Erdleitung ist und die zweite Versorgungsleitung eine Energieleitung ist.

7. Vorrichtung nach Anspruch 3, 4 oder 5, bei der die erste Versorgungsleitung eine Energieleitung und die zweite Versorgungsleitung eine Erdleitung ist.

8. Vorrichtung nach einem der Ansprüche 3 bis 7, bei der die erste Versorgungsleitung eine vollständige Schleife um die Speicherzellen und Dekodierschaltungen bildet.

9. Vorrichtung nach einem der Ansprüche 3 bis 7, bei der die erste Versorgungsleitung eine diskontinuierliche Schleife bildet, um die Speicherzellen und Dekodierschaltungen, dabei einen Spalt bildend, durch den Verbindungen von der zweiten Energieversorgungsleitung und von einer Signalleitung oder Signalleitungen zu den Dekodierschaltungen hergestellt werden.

10. Vorrichtung nach einem der Ansprüche 3 bis 7, bei der die erste Versorgungsleitung freie Enden hat, zwischen denen ein Spalt gebildet ist, durch den eine Verbindung von der zweiten Energieversorgungsleitung zu den Speicherzellen und Dekodierschaltungen hergestellt ist, und bei der die erste Versorgungsleitung einen Zweig aufweist, der sich über den Dekodierschaltungen erstreckt, zur Verbindung zu einer Steuerschaltung oder zu Steuerschaltungen.

11. Vorrichtung nach einem der Ansprüche 3 bis 10, bei der die oder jede Signalleitung eine komplette Schleife bildet.

## Revendications

1. Circuit intégré à semi-conducteur comportant plusieurs circuits internes disposés en son centre, plusieurs circuits de commande disposés dans une région extérieure aux circuits internes, plusieurs lignes de connexion qui relient les circuits de commande et les circuits internes, plusieurs lignes de signaux qui relient les circuits de commande entre eux et une première ligne d'alimentation en courant (qui peut être une ligne de masse) qui alimente les circuits internes et les circuits de commande, dans lequel les lignes de signaux et la première ligne d'alimentation en courant sont disposées vers l'extérieur d'une région dans laquelle sont disposées les lignes de connexion qui relient les circuits de commande et les circuits internes.

2. Dispositif selon la revendication 1, dans lequel la première ligne d'alimentation en courant est disposée vers l'intérieur d'une région dans laquelle sont disposées les lignes de signaux et vers l'intérieur d'une région dans laquelle les circuits de commande sont disposés, ou au-dessus des circuits de commande.

3. Dispositif selon la revendication 2, consistant en une mémoire comportant plusieurs cellules de mémoire et un circuit décodeur comme lesdits plusieurs circuits internes, dans lequel une seconde ligne d'alimentation en courant (qui peut être une ligne de masse) est disposée dans une région extérieure à la région dans laquelle sont disposées lesdites lignes de signaux.

4. Dispositif selon la revendication 3, dans lequel le ou chaque circuit de commande est disposé dans une région extérieure à la région dans laquelle est disposée la première ligne d'alimentation.

5. Dispositif selon la revendication 3, dans lequel le ou chaque circuit de commande est disposé au-dessous de la première ligne d'alimentation.

6. Dispositif selon la revendication 3, 4 ou 5, dans lequel la première ligne d'alimentation est une ligne de masse et la seconde ligne d'alimentation est une ligne de courant.

7. Dispositif selon la revendication 3, 4 ou 5, dans lequel la première ligne d'alimentation est une ligne de courant et la seconde ligne d'alimentation est une ligne de masse.

8. Dispositif selon l'une quelconque des revendications 3 à 7, dans lequel la première ligne d'alimentation forme une boucle complète autour des cellules de mémoire et des circuits décodeurs.

9. Dispositif selon l'une quelconque des revendications 3 à 7, dans lequel la première ligne d'alimentation forme une boucle discontinue autour des cellules de mémoire et des circuits décodeurs, permettant un intervalle dans lequel des connexions sont établies depuis la seconde ligne d'alimentation en courant et depuis une ligne de signaux ou des lignes de signaux vers les circuits décodeurs.

10. Dispositif selon l'une quelconque des revendications 3 à 7, dans lequel la première ligne d'alimentation comporte des extrémités libres entre lesquelles un intervalle est formé dans lequel une connexion est établie depuis la seconde ligne d'alimentation en courant vers les cellules de mémoire et les circuits décodeurs et dans lequel la première ligne d'alimentation est prévue avec une dérivation s'étendant au-dessus des circuits décodeurs pour être connectée à un circuit de commande ou des circuits de commande.

11. Dispositif selon l'une quelconque des revendications 3 à 10, dans lequel l'un ou chaque ligne de signaux forme une boucle complète.

# Fig. 1

# Fig. 2

# Fig. 3

# Fig. 4